# EUROPEAN PATENT APPLICATION

(11) **EP 4 686 182 A2**
(43) Date of publication of application: **28.01.2026**
(21) Application number: 25222215.3
(22) Date of filing: 02.11.2023
(51) Int. Cl.: H04M 1/02

(54) **ELECTRONIC DEVICE COMPRISING WATERPROOF STRUCTURE**

(30) Priority: 30.11.2022 KR 20220164311; 22.12.2022 KR 20220181512
(62) Divisional of application: 23898109.6
(71) Applicant: Samsung Electronics Co., Ltd., Suwon-si, Gyeonggi-do 16677 (KR)
(72) Inventor: Jung, Minsu, 16677 Suwon-si, Gyeonggi-do (KR); Kim, Gyeongtae, 16677 Suwon-si, Gyeonggi-do (KR)
(74) Representative: Gulde & Partner

(57) **Abstract**

According to the invention, an electronic device (100) is provided, which comprises: a first housing (110) having a through-hole (1131c); a second housing (120); a hinge device (140) coupling the first housing (110) and the second housing (120); a flexible printed circuit board (160) disposed to penetrate through the through-hole (1131c), and electrically connected with a first electronic component in the first housing (110) and a second electronic component in the second housing (120). The electronic device (100) comprises a stiffener (161) disposed on the flexible printed circuit board (160) and attached to the first housing (110), a first waterproof member (210) disposed in or adjacent to the through-hole (1131c), such that the stiffener (161) and the first waterproof member (210), when coupled to each other, form a loop structure having an opening (214) at least partially overlapped with the through-hole (1131c). The electronic device (100) comprises a second waterproof member (220) disposed to seal the opening (214), wherein the second waterproof member (210) seals the through hole (1131c). The electronic device (100) comprises a fixing bracket (230) disposed over the stiffener (161) and the first waterproof member (210) to cover the opening (214).

## Description

### [Technical Field]

Various embodiments of this disclosure relate to an electronic device including a waterproof structure.

### [Background Art]

As the functional gap among electronic devices from different manufacturers has significantly decreased, electronic devices are gradually becoming slimmer to satisfy consumer purchasing desires. At the same time, the rigidity of electronic devices is increasing, and their design aspects are being strengthened, while improvements are being made to differentiate their functional elements. An electronic device may have a transformable structure that allows for convenient portability and the ability to use a large-screen display when in use. For example, an electronic device may include a foldable electronic device that is rotatably coupled to each other through a hinge device. The foldable electronic device needs to be designed to ensure efficient layout of internal electronic components and to secure operational reliability in response to folding operations.

### [Disclosure of Invention]

### [Technical Problem]

An electronic device may include a foldable electronic device that includes a first housing and a second housing that is foldably connected to the first housing through a hinge device (e.g., hinge module, hinge structure, or hinge assembly). The first housing and the second housing are rotatably coupled to each other through the hinge device, thereby ensuring operational reliability for the folding state and/or unfolding state. The foldable electronic device may be operated in an in-folding manner and/or an out-folding manner by rotating the first housing relative to the second housing through the hinge device in a range from 0 to 360 degrees. The foldable electronic device may include a flexible display that is disposed to be supported by the first housing and the second housing in a state where it is opened at 180 degrees.

The foldable electronic device may include a flexible printed circuit board (FPCB) that electrically connects the first housing and the second housing. The flexible printed circuit board may be disposed in the inner space of a hinge housing that accommodates the hinge device, and include a bending portion formed in a bent shape (e.g., shape bent at least once) that is at least partially elastic (e.g., resiliency) to accommodate a length that is deformed according to the folding operation of the foldable electronic device. The flexible printed circuit board may be disposed such that one end penetrates through at least a part of the first housing and then is electrically connected to a first printed circuit board (e.g., main printed circuit board), and the other end penetrates through at least a part of the second housing and then is electrically connected to a second printed circuit board (e.g., sub printed circuit board).

The foldable electronic device may include a fixation structure formed in a portion that is introduced into the first housing and second housing from the bending portion. For example, the fixation structure may be configured in a manner where a stiffener disposed on the flexible printed circuit board is attached to at least a part of the first housing or second housing. The foldable electronic device may include a waterproof structure to prevent or reduce the ingress of external moisture or foreign substances, which is provided by the flexible printed circuit board disposed in a manner that penetrates through each housing. Such a waterproof structure may be configured in a manner that seals a through-hole through which the flexible printed circuit board penetrates the first housing and second housing.

However, with the slimming down of the foldable electronic device or the diversification of the folding method of the flexible display (e.g., folding into a droplet shape), a space in which the bending portion of the flexible printed circuit board is accommodated, from the fixation structure to the hinge housing inner space (e.g., space where elastic deformation of a bending area is required), may become narrower. For example, as a space of a folding area of the flexible display increases, the space required for the bending portion of the flexible printed circuit board may also increase, which may make it difficult to slim down the electronic device.

According to various embodiments of the present disclosure, an electronic device including a waterproof structure that can assist in slimming down the electronic device may be provided.

According to various embodiments, an electronic device including a waterproof structure that can assist in slimming down the electronic device may be provided, while simultaneously inducing smooth operation of the electronic device by securing a space for the elastic deformation of the flexible printed circuit board.

According to various embodiments, an electronic device including a waterproof structure that can assist in improving assembly may be provided.

### [Solution to Problem]

The present invention is directed to subject-matter as defined in the claims.

### [Advantageous Effects of Invention]

The electronic device according to exemplary embodiments of the present disclosure, where the fixation structure and waterproof structure for the flexible printed circuit board are implemented together at the through-hole, can improve flexibility by securing the driving length of the flexible printed circuit board according to the folding operation of the electronic device, and can assist in slimming down the electronic device without increasing its thickness. In addition, the waterproof structure of the flexible printed circuit board is disposed together with the fixation structure, which can assist in improving assembly.

In addition, various effects that can be directly or indirectly identified through the present document may be provided.

The effects obtained by the present disclosure are not limited to the aforementioned effects, and other effects, which are not mentioned above, will be clearly understood by those skilled in the art from the following description.

### [Brief Description of Drawings]

In connection with the description of the drawings, the same or similar reference numerals may be used for the same or similar constituent elements.
FIG. 1A is a perspective view of a front surface of an electronic device illustrating an unfolding state (or flat state) according to various embodiments of the present disclosure.
FIG. 1B is a top view illustrating the front surface of the electronic device in the unfolding state according to various embodiments of the present disclosure.
FIG. 1C is a top view illustrating a rear surface of the electronic device in the unfolding state according to various embodiments of the present disclosure.
FIG. 2A is a perspective view of the electronic device in a folding state according to various embodiments of the present disclosure.
FIG. 2B is a perspective view of the electronic device in an intermediate state according to various embodiments of the present disclosure.
FIG. 3 is an exploded perspective view of the electronic device according to various embodiments of the present disclosure.
FIG. 4 is a partial cross-sectional view of the electronic device taken along line 4-4 of FIG. 1C according to various embodiments of the present disclosure.
FIG. 5A is an exploded perspective view of a waterproof structure according to various embodiments of the present disclosure.
FIG. 5B is a flowchart illustrating the assembly sequence of the waterproof structure according to various embodiments of the present disclosure.
FIGS. 6A to 6G are views illustrating the coupling process according to various embodiments of the present disclosure.

### [Mode for the Invention]

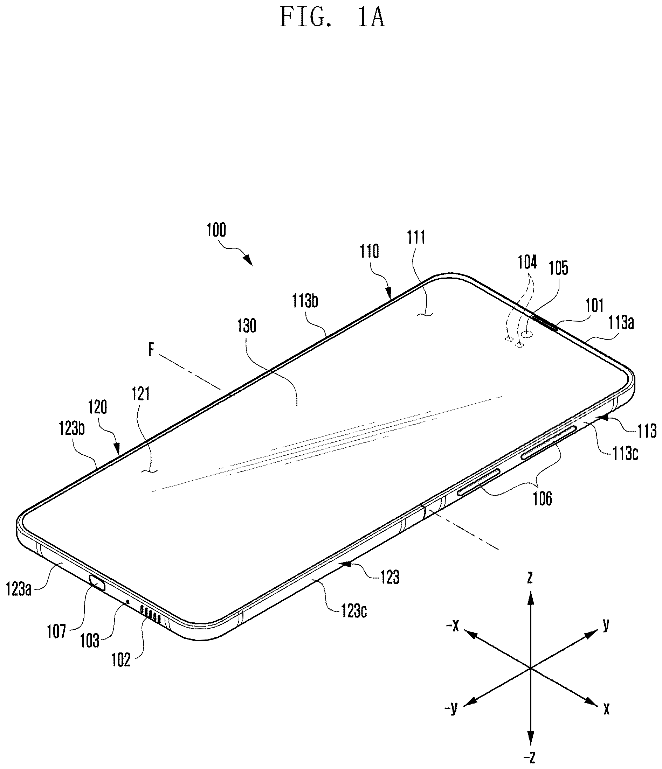

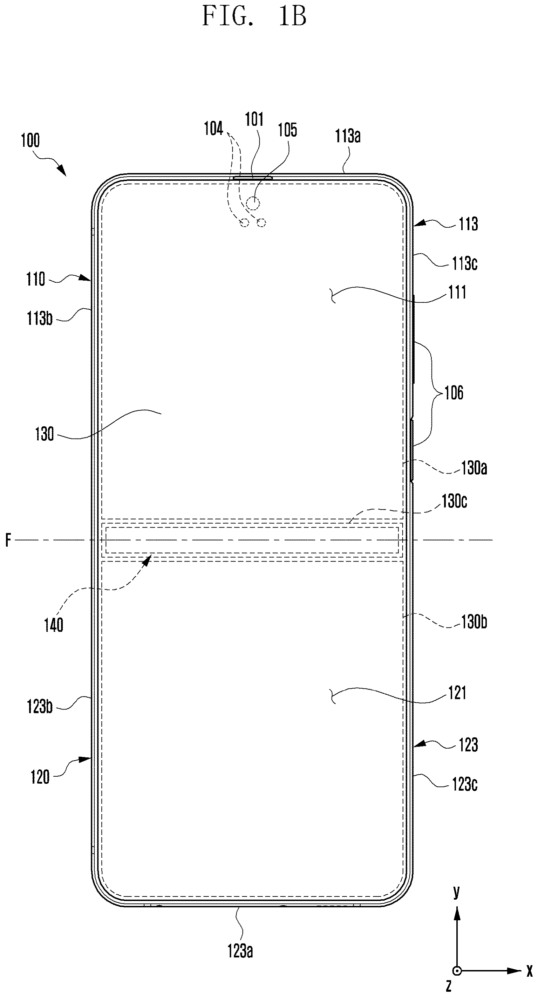

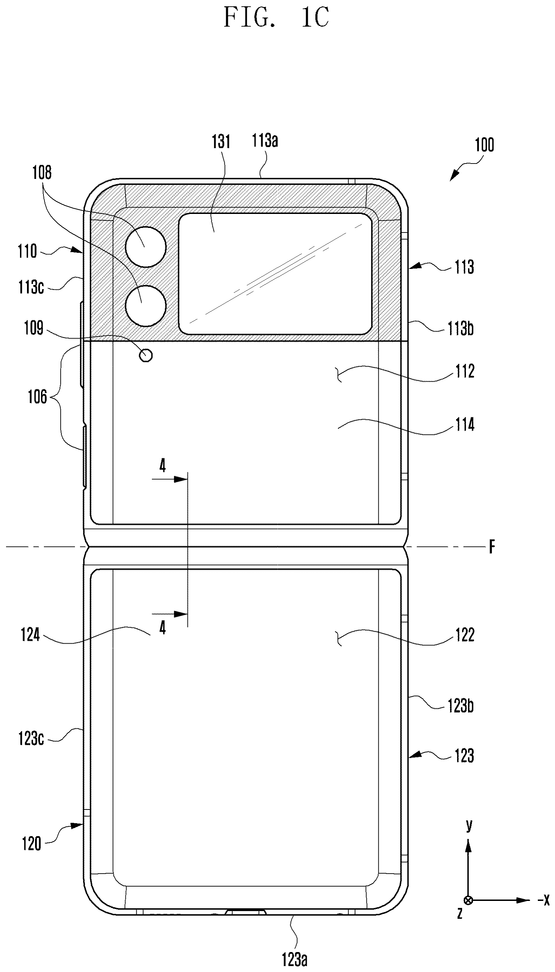

FIG. 1A is a perspective view of an electronic device illustrating an unfolded state (or flat state) of the electronic device according to various embodiments of the disclosure. FIG. 1B is a plan view illustrating a front surface of an electronic device in an unfolded state of the electronic device according to various embodiments of the disclosure. FIG. 1C is a plan view illustrating a rear surface of an electronic device in an unfolded state according to various embodiments of the disclosure.

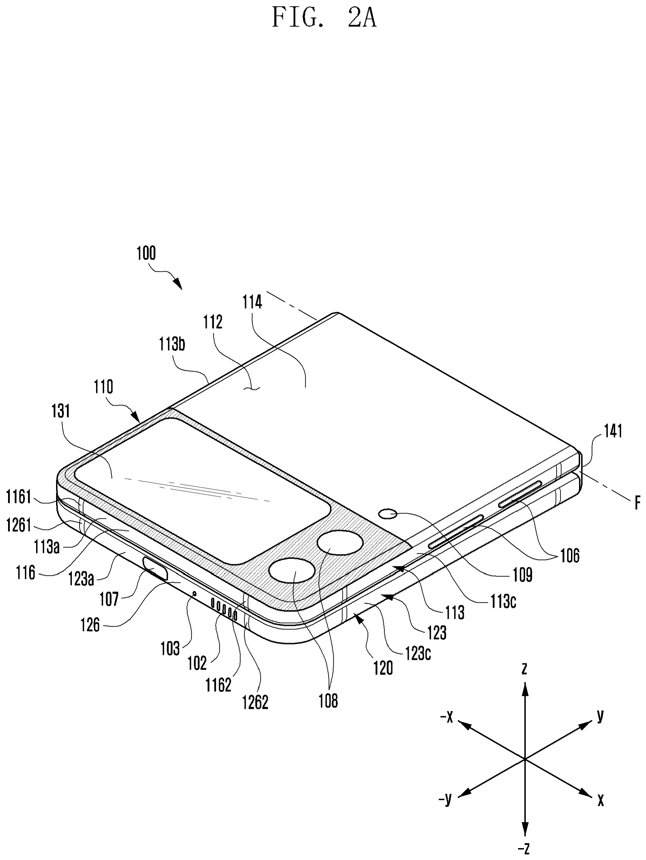

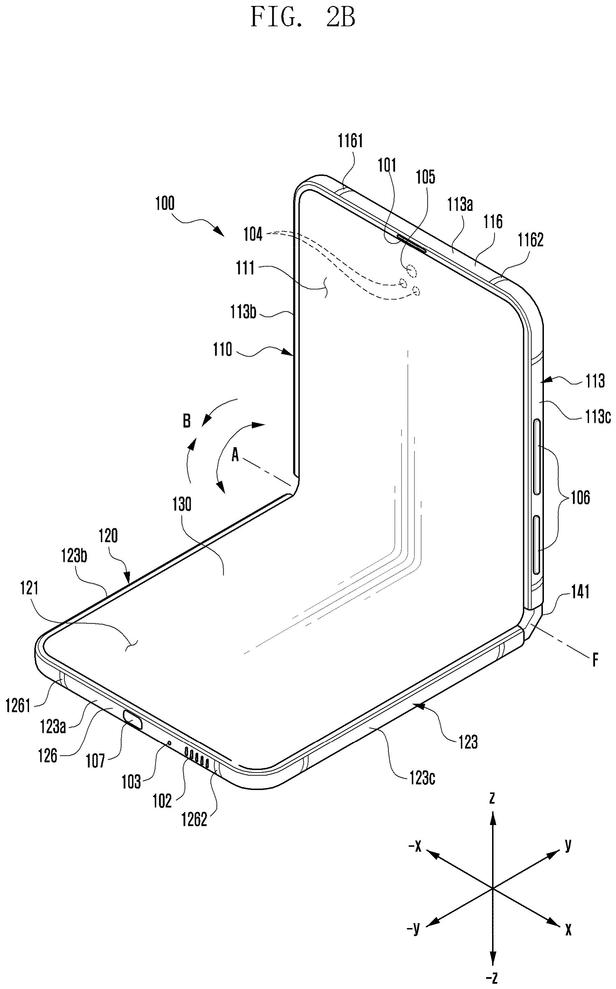

FIG. 2A is a perspective view of an electronic device illustrating a folded state of the electronic device according to various embodiments of the disclosure. FIG. 2B is a perspective view of an electronic device illustrating an intermediate state of the electronic device according to various embodiments of the disclosure.

With reference to FIGS. 1A to 2B, an electronic device 100 may include first and second housings 110 and 120 (e.g., foldable housing structure) combined with each other in a foldable manner based on a hinge device (e.g., hinge device 140 of FIG. 1B). In an embodiment, the hinge device (e.g., hinge device 140 of FIG. 1B) may be disposed in an X-axis direction or in a Y-axis direction. According to an embodiment, the electronic device 100 may include a first display 130 (e.g., flexible display, foldable display, or main display) disposed in an area (e.g., recess) formed by the first and second housings 110 and 120. According to an embodiment, the first housing 110 and the second housing 120 may be disposed on both sides around a folding axis F, and may have a substantially symmetrical shape about the folding axis F. According to an embodiment, an angle or a distance between the first housing 110 and the second housing 120 may differ depending on the state of the electronic device 100. For example, depending on whether the electronic device is in an unfolded state (or flat state), in a folded state, or in an intermediate state, the angle or the distance between the first housing 110 and the second housing 120 may differ.

According to an embodiment, in the unfolded state of the electronic device 100, the first housing 110 may include a first surface 111 directed in a first direction (e.g., front direction) (z-axis direction), and a second surface 112 directed in a second direction (e.g., rear direction) (-z-axis direction) opposite to the first surface 111. According to an embodiment, in the unfolded state of the electronic device 100, the second housing 120 may include a third surface 121 directed in the first direction (z-axis direction), and a fourth surface 122 directed in the second direction (-z-axis direction). According to an embodiment, in the unfolded state of the electronic device 100, the first surface 111 of the first housing 110 and the third surface 121 of the second housing 120 may be directed in substantially the same first direction (z-axis direction). In an embodiment, in the folded state of the electronic device 100, the first surface 111 of the first housing 110 and the third surface 121 of the second housing 120 may face each other. According to an embodiment, in the unfolded state of the electronic device 100, the second surface 112 of the first housing 110 and the fourth surface 122 of the second housing 120 may be directed in substantially the same second direction (-z-axis direction). In an embodiment, in the folded state of the electronic device 100, the second surface 112 of the first housing and the fourth surface 122 of the second housing 120 may be directed in opposite directions. For example, in the folded state of the electronic device 100, the second surface 112 may be directed in the first direction (z-axis direction), and the fourth surface 122 may be directed in the second direction (-z-axis direction). In this case, the first display 130 may not be viewed from outside (in-folding manner). In an embodiment, the electronic device 100 may be folded so that the second surface 112 of the first housing 110 and the fourth surface 122 of the second housing 120 face each other. In this case, the first display 130 may be disposed to be viewed from the outside (out-folding manner).

According to various embodiments, the first housing 110 (e.g., first housing structure) may include a first lateral member 113 forming the appearance of the electronic device 100, and a first rear cover 114 combined with the first lateral member 113, and forming at least a part of the second surface 112 of the electronic device 100. According to an embodiment, the first lateral member 113 may include a first side surface 113a, a second side surface 113b extending from one end of the first side surface 113a, and a third side surface 113c extending from the other end of the first side surface 113a. According to an embodiment, the first lateral member 113 may be formed in a quadrangular (e.g., square or rectangular) shape through the first side surface 113a, the second side surface 113b, and the third side surface 113c.

According to various embodiments, the second housing 120 (e.g., second housing structure) may include a second lateral member 123 forming the appearance of the electronic device 100 at least partly, and a second lateral cover 124 combined with the second lateral member 123, and forming at least a part of the fourth surface 122 of the electronic device 100. According to an embodiment, the second lateral member 123 may include a fourth side surface 123a, a fifth side surface 123b extending from one end of the fourth side surface 123a, and a sixth side surface 123c extending from the other end of the fourth side surface 123a. According to an embodiment, the second lateral member 123 may be formed in a quadrangular shape through the fourth side surface 123a, the fifth side surface 123b, and the sixth side surface 123c.

According to various embodiments, the first and second housings 110 and 120 are not limited to the illustrated shapes and combinations, but may be implemented by combinations and/or compositions of other shapes or components. In an embodiment, the first lateral member 113 may be integrally formed with the first rear cover 114, and the second lateral member 123 may be integrally formed with the second rear cover 124.

According to various embodiments, in the unfolded state of the electronic device 100, the second side surface 113b of the first lateral member 113 and the fifth side surface 123b of the second lateral member 123 may be connected to each other without a gap. According to an embodiment, in the unfolded state of the electronic device 100, the third side surface 113c of the first lateral member 113 and the sixth side surface 123c of the second lateral member 123 may be connected to each other without a gap. According to an embodiment, in the unfolded state of the electronic device 100, the sum of the lengths of the second side surface 113b and the fifth side surface 123b may be configured to be longer than the length of the first side surface 113a and/or the fourth side surface 123a. According to an embodiment, in the unfolded state of the electronic device 100, the sum of the lengths of the third side surface 113c and the sixth side surface 123c may be configured to be longer than the length of the first side surface 113a and/or the fourth side surface 123a.

With reference to FIGS. 2A and 2B, the first lateral member 113 and/or the second lateral member 123 may be formed of metal, or may further include polymer that is injected into metal. According to an embodiment, the first lateral member 113 and/or the second lateral member 123 may include at least one conductive part 116 and/or 126 electrically segmented through at least one segment part 1161, 1162 and/or 1261, 1262 formed of polymer. In this case, the at least one conductive part 116 and/or 126 may be electrically connected to a wireless communication circuit included in the electronic device 100, and thus may be used as at least a part of an antenna that operates in at least one designated band (e.g., legacy band).

According to various embodiments, the first rear cover 114 and/or the second rear cover 124 may be formed of, for example, at least one of coated or colored glass, ceramic, polymer, or metal (e.g., aluminum, stainless steel (STS), or magnesium) or a combination of at least two thereof.

According to various embodiments, the first display 130 may be disposed to extend from the first surface 111 of the first housing 110 to at least a part of the third surface 121 of the second housing 120 across the hinge device (e.g., hinge device 140 of FIG. 1B). In an embodiment, the first display 130 may include a first area 130a substantially corresponding to the first surface 111, a second area 130b corresponding to the second surface 121, and a third area 130c (e.g., flexible area or folding area) connecting the first area 130a and the second area 130b to each other. According to an embodiment, the third area 130c may be a part of the first area 120a and/or the second area 130b, and may be disposed at a location corresponding to the hinge device (e.g., hinge device 140 of FIG. 1B). According to an embodiment, the electronic device 100 may include a hinge housing 141 (e.g., hinge cover) supporting the hinge device (e.g., hinge device 140 of FIG. 1B). In an embodiment, the hinge housing 141 may be disposed to be exposed to outside when the electronic device 100 is in a folded state, and not to be viewed from the outside as being drawn into an inner space of the first housing 110 and an inner space of the second housing 120 when the electronic device 100 is in an unfolded state.

According to various embodiments, the electronic device 100 may include a second display 131 (e.g., sub-display) disposed separately from the first display 130. According to an embodiment, the second display 131 may be disposed to be exposed at least partly on the second surface 112 of the first housing 110. In an embodiment, when the electronic device 100 is in the folded state, the second display 131 may display at least a part of state information of the electronic device 100 in replacement of at least a part of a display function of the first display 130. According to an embodiment, the second display 131 may be disposed to be viewed from the outside through at least a partial area of the first rear cover 114. In an embodiment, the second display 131 may be disposed on the fourth surface 122 of the second housing 120. In this case, the second display 131 may be disposed to be viewed from the outside through at least a partial area of the second rear cover 124.

According to various embodiments, the electronic device 100 may include at least one of an input device 103 (e.g., microphone), sound output devices 101 and 102, a sensor module 104, camera devices 105 and 108, a key input device 106, or a connector port 107. In an illustrated embodiment, although the input device 103 (e.g., microphone), the sound output devices 101 and 102, the sensor module 104, the camera devices 105 and 108, the key input device 106, or the connector port 107 are illustrated as hole or circular shaped elements formed on the first housing 110 or the second housing 120, they are exemplarily illustrated for explanation, but are not limited thereto. According to various embodiments, the input device 103 may include at least one microphone 103 disposed on the second housing 120. In an embodiment, the input device 103 may include a plurality of microphones 103 disposed to sense the sound direction. In an embodiment, the plurality of microphone 103 may be disposed at proper locations on the first housing 110 and/or the second housing 120. According to an embodiment, the sound output devices 101 and 102 may include at least one speaker 101 and 102. According to an embodiment, the at least one speaker 101 and 102 may include a receiver 101 for call disposed on the first housing 110, and the speaker 102 disposed on the second housing 120. In an embodiment, the input device 103, the sound output devices 101 and 102, and the connector port 107 may be disposed in a space provided in the first housing 110 and/or the second housing 120 of the electronic device 100, and may be exposed to an external environment through at least one hole formed on the first housing 110 and/or the second housing 120. According to an embodiment, the at least one connector port 107 may be used to transmit and receive power and/or data to and from an external electronic device. In an embodiment, the at least one connector port (e.g., ear jack hole) may accommodate a connector (e.g., ear jack) for transmitting and receiving an audio signal to and from the external electronic device. In an embodiment, the hole formed on the first housing 110 and/or the second housing 120 may be commonly used for the input device 103 and the sound output devices 101 and 102. In an embodiment, the sound output devices 101 and 102 may include a speaker (e.g., piezo-electric speaker) that is not exposed through the hole formed on the first housing 110 and/or the second housing 120.

According to various embodiments, the sensor module 104 may generate an electrical signal or a data value corresponding to an internal operation state of the electronic device 100 or an external environment state. According to an embodiment, the sensor module 104 may detect the external environment through the first surface 111 of the first housing 110. In an embodiment, the electronic device 100 may further include at least one sensor module disposed to detect the external environment through the second surface 112 of the first housing 110. According to an embodiment, the sensor module 104 (e.g., illumination sensor) may be disposed to detect the external environment through the first display 130 under the first display 130. According to an embodiment, the sensor module 104 may include at least one of a gesture sensor, a gyro sensor, a barometric pressure sensor, a magnetic sensor, an acceleration sensor, a grip sensor, a color sensor, an infrared (IR) sensor, a biosensor, a temperature sensor, a humidity sensor, an illumination sensor, a proximity sensor, a biosensor, an ultrasonic sensor, or an illumination sensor 104.

According to various embodiments, the camera devices 105 and 108 may include the first camera device 105 (e.g., front camera device) disposed on the first surface 111 of the first housing 110, and the second camera device 108 disposed on the second surface 112 of the first housing 110. In an embodiment, the electronic device 100 may further include a flash 109 disposed near the second camera device 108. According to an embodiment, the camera devices 105 and 108 may include at least one lens, an image sensor, and/or an image signal processor. According to an embodiment, the camera devices 105 and 108 may be disposed so that two or more lenses (e.g., wide angle lens, ultra wide angle lens, or telephoto lens) and two or more image sensors are located on one surface (e.g., first surface 111, second surface 112, third surface 121, or fourth surface 122) of the electronic device 100. In an embodiment, the camera devices 105 and 108 may include lenses for time of flight (TOF) and/or image sensors.

According to various embodiments, the key input device 106 (e.g., key buttons) may be disposed on the third side surface 113c of the first lateral member 113 of the first housing 110. In an embodiment, the key input device 106 may be disposed on at least one side surface of other side surfaces 113a and 113b of the first housing 110 and/or side surfaces 123a, 123b, and 123c of the second housing 120. In an embodiment, the electronic device 100 may not include some or all of the key input devices 106, and the non-included key input device 106 may be implemented in another form, such as a soft key, on the first display 130. In an embodiment, the key input device 106 may be implemented by using the pressure sensor included in the first display 130.

According to various embodiments, one of the camera devices 105 and 108 (e.g., first camera device 105) or the sensor module 104 may be disposed to be exposed through the first display 130. According to an embodiment, the first camera device 105 or the sensor module 104 may be optically exposed to the outside through an opening (e.g., through-hole) formed at least partly on the first display 130 in the inner space of the electronic device 100. According to an embodiment, at least a part of the sensor module 104 may be disposed not to be visually exposed through the first display 130 in the inner space of the electronic device 100. With reference to FIG. 2B, the electronic device 100 may operate to maintain at least one designated folding angle in an intermediate state through the hinge device (e.g., hinge device 140 of FIG. 1B). In this case, the electronic device 100 may control the first display 130 so that different kinds of content are displayed on the display area corresponding to the first surface 111 and the display area corresponding to the third surface 121. According to an embodiment, the electronic device 100 may operate in substantially the unfolded state (e.g., unfolded state of FIG. 1A) and/or in substantially the folded state (e.g., folded state of FIG. 2A) based on a specific folding angle (e.g., angle between the first housing 110 and the second housing 120 when the electronic device 100 is in the intermediate state) through the hinge device (e.g., hinge device 140 of FIG. 1B). In an embodiment, if a pressing force is provided in an unfolding direction (direction A) in a state where the electronic device 100 is unfolded at the specific folding angle through the hinge device (e.g., hinge device 140 of FIG. 1B), the electronic device 100 may operate to be transitioned to the unfolded state (e.g., unfolded state of FIG. 1A). In an embodiment, if the pressing force is provided in a folding direction (direction B) in a state where the electronic device 100 is unfolded at the specific folding angle through the hinge device (e.g., hinge device 140 of FIG. 1B), the electronic device 100 may operate to be transitioned to the folded state (e.g., folded state of FIG. 2A). In an embodiment, the electronic device 100 may operate to maintain the unfolded state (not illustrated) at various angles through the hinge device (e.g., hinge device 140 of FIG. 1B) (free-stop function).

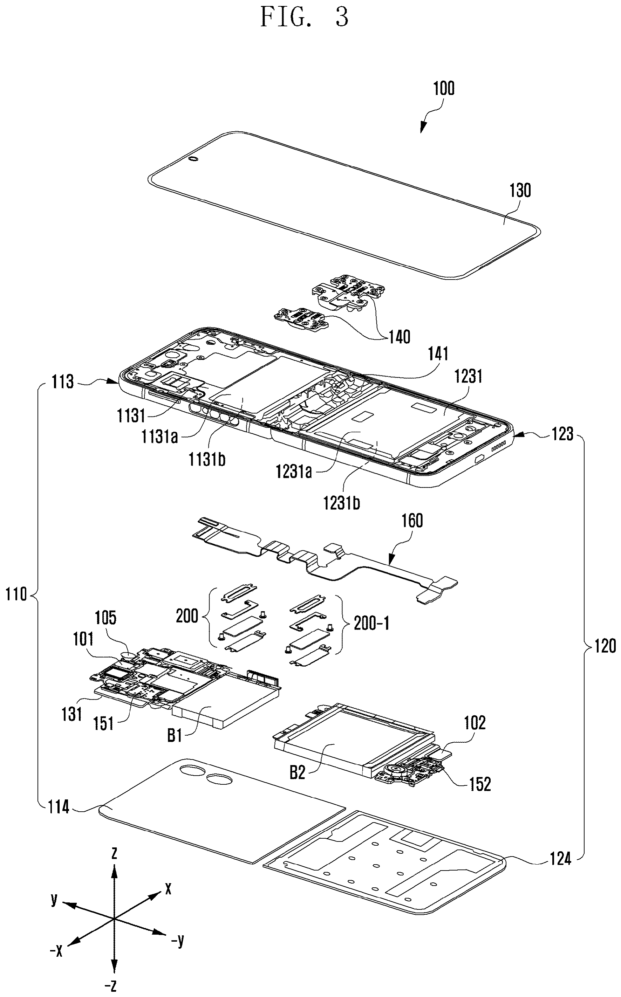

FIG. 3 is an exploded perspective view of the electronic device according to various embodiments of the present disclosure.

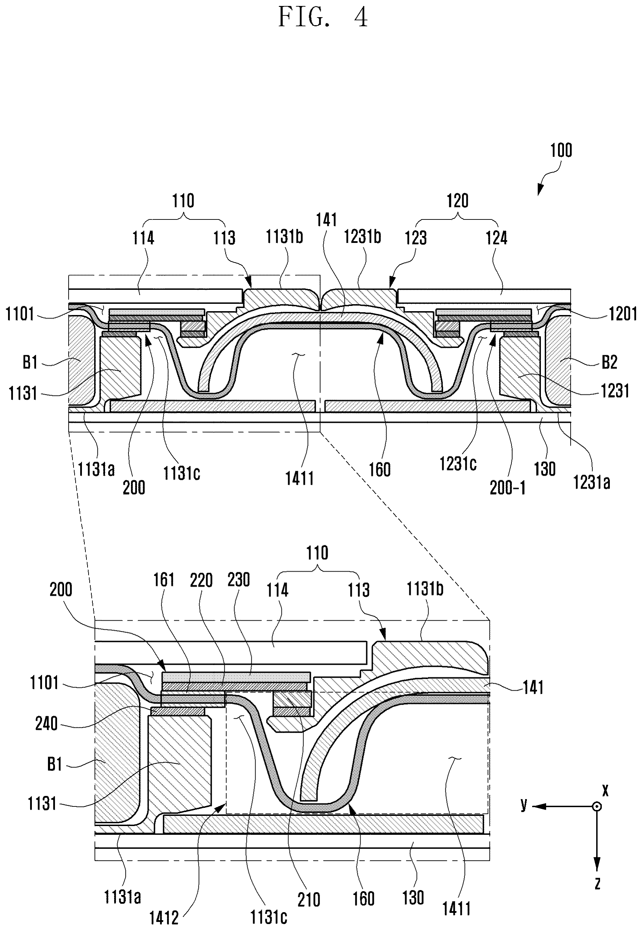

With reference to FIG. 3, the electronic device 100 may include a first housing 110 (e.g., first housing structure) including a first lateral member 113 (e.g., first lateral frame or first lateral bezel), a second housing 120 (e.g., second housing structure) which is foldably connected to the first housing 110 through a hinge device 140 and includes a second lateral member 123 (e.g., second lateral frame or second lateral bezel), and a first display 130 (e.g., flexible display) disposed to be supported by the first housing 110 and the second housing 120. In an embodiment, the first housing 110 may include a first rear surface cover 114 coupled with the first lateral member 113. In an embodiment, the first housing 110 may include a first support member 1131 (e.g., first support plate) that extends at least partially from the first lateral member 113, and includes a first surface 1131a and a second surface 1131b, which faces in the opposite direction to the first surface 1131a. In an embodiment, the first housing 110 may include a first space (e.g., first space 1101 in FIG. 4) formed between the second surface 1131b of the first support member 1131 and the first rear surface cover 114. In an embodiment, the second housing 120 may include a second rear surface cover 124 coupled with the second lateral member 123. In an embodiment, the second housing 120 may include a second support member 1231 (e.g., second support plate) that extends at least partially from the second lateral member 123, and includes a third surface 1231a, which faces in the same direction as the first surface 1131a, and a fourth surface 1231b, which faces in the opposite direction to the third surface 1231a, in the unfolding state. In an embodiment, the second housing 120 may include a second space (e.g., second space 1201 in FIG. 4) formed between the fourth surface 1231b and the second rear surface cover 124. In an embodiment, the first support member 1131 may be integrally formed with the first lateral member 113 or may be structurally coupled with the first lateral member 113. In an embodiment, the second support member 1231 may be integrally formed with the second lateral member 123 or structurally coupled with the second lateral member 123. In an embodiment, the first display 130 may be disposed to be supported by the first surface 1131a of the first support member 1131 and the third surface 1231a of the second support member 1231. In an embodiment, the first lateral member 113 and the first rear surface cover 114 may be integrally formed. In an embodiment, the second lateral member 123 and the second rear surface cover 124 may be integrally formed. In an embodiment, the electronic device 100 may include the second display 131 disposed in the first space 1101 and externally visible through at least some area of the first rear surface cover 114.

According to various embodiments, the electronic device 100 may include a first printed circuit board 151 (e.g., first printed circuit board assembly or main printed circuit board) disposed in the first space 1101 and at least one electronic component (e.g., camera module 105, receiver 101 or first batteries B1) disposed on the first printed circuit board 151. In an embodiment, the electronic device 100 may include a second printed circuit board 152 (e.g., second printed circuit board assembly or sub printed circuit board) disposed in the second space 1201, and at least one electronic component (e.g., speaker 102 or batteries B2) disposed on the second printed circuit board. In an embodiment, the electronic device may include a flexible printed circuit board 160 (e.g., flexible substrate, FPCB, or wiring member) that electrically connects the first printed circuit board 151 and the second printed circuit board 152 through the hinge device 140. In an embodiment, the electronic device 100 may include a hinge housing 141 disposed in an area corresponding to the hinge device 140. In an embodiment, the hinge device 140 may be disposed by the hinge housing 141 to not be visible from the outside of the electronic device 100. In an embodiment, at least a portion of the flexible printed circuit board 160 may be disposed in a space (e.g., space 1411 in FIG. 4) formed by the hinge housing 141 to be elastically deformable and not visible from the outside.

According to an exemplary embodiment of the present disclosure, the flexible printed circuit board 160 may be disposed in an area corresponding to the hinge device 140 (e.g., space 1411 in FIG. 4) to be bent once or more in different directions. In an embodiment, the bent area of the flexible printed circuit board 160 may accommodate the length changes of the flexible printed circuit board 160, which may stretch or shrink according to the folding operation of the electronic device 100. In an embodiment, the electronic device 100 may include a waterproof structure 200 and 200-1 for the flexible printed circuit board 160. For example, the waterproof structure 200 and 200-1 may include a first waterproof structure 200 that seals a first through-hole (e.g., first through-hole 1131c in FIG. 4) formed in the first support member 1131 to block external moisture or foreign substances when the flexible printed circuit board 160 is electrically connected to the first printed circuit board 151 through the first through-hole 1131c, and a second waterproof structure 200-1 that seals a second through-hole 1231c formed in the second support member 1231 to block external moisture or foreign substances when the flexible printed circuit board 160 is electrically connected to the second printed circuit board 152 through the second through-hole 1231c. In an embodiment, the electronic device 100 may include a fixation structure configured to prevent the movement of the flexible printed circuit board 160, which is accommodated in the first housing 110 and second housing 120, when the electronic device 100 performs a folding operation. The electronic device 100 according to an exemplary embodiment of the present disclosure, in which the fixation structure is configured together with the waterproof structure 200 and 200-1, can help in slimming down the electronic device 100 and/or improving assembly by securing a sufficient bending area for the flexible printed circuit board 160 (e.g., by securing enough driving length for the flexible printed circuit board), without increasing the thickness of the electronic device 100, compared to a layout structure where the fixation structure is disposed separately.

FIG. 4 is a partial cross-sectional view of the electronic device taken along line 4-4 of FIG. 1C according to various embodiments of the present disclosure.

With reference to FIG. 4, the electronic device 100 may include the second housing 120 that is rotatably coupled relative to the first housing 110 through a hinge device (e.g., hinge device 140 in FIG. 3), and a flexible display 130 (e.g., first display 130 in FIG. 3) disposed to be supported by the first housing 110 and the second housing 120. In an embodiment, the first housing 110 may include the first lateral member 113 and the first rear surface cover 114, which is coupled with the first lateral member 113 and forms the first space 1101. In an embodiment, the second housing 120 may include the second lateral member 123 and the second rear surface cover 124, which is coupled with the second lateral member 123 and forms the second space 1201. In an embodiment, the first lateral member 113 may at least partially form the appearance of the side surface (e.g., first side surface 113a, second side surface 113b, and third side surface 113c in FIG. 1A) of the electronic device 100, and may include the first support member 1131 that extends from the side surface into at least a portion of the first space 1101. In an embodiment, the first space 1101 may be provided through the coupling of the first support member 1131 and the first rear surface cover 114. In an embodiment, the second lateral member 123 may at least partially form the appearance of the side surface (e.g., fourth side surface 123a, fifth side surface 123b, and sixth side surface 123c in FIG. 1A) of the electronic device 100, and may include the second support member 1231 that extends from the side surface into at least a portion of the second space 1201. In an embodiment, the second space 1201 may be provided through the coupling of the second support member 1231 and the second rear surface cover 124. In an embodiment, the first support member 1131 may include the first surface 1131a facing a first direction (e.g., z-axis direction) and the second surface 1131b facing a second direction (e.g., -z-axis direction), opposite to the first direction, in the unfolding state. In an embodiment, the second support member 1231 may include the third surface 1231a facing the same direction as the first surface 1131a, and the fourth surface 1231b facing the opposite direction to the third surface 1231a, in the unfolding state. In an embodiment, the flexible display 130 may be disposed to be supported by the first surface 1131a and the third surface 1231a. In an embodiment, the electronic device 100 may include the hinge housing 141 that includes an accommodation space 1411 that is disposed between the first housing 110 and the second housing 120 and is intended to accommodate the hinge device (e.g., hinge device 140 in FIG. 3), such that the hinge device is not visible from the outside. In an embodiment, the hinge housing 141 may be disposed in such a manner that, when the electronic device 100 is in the folding state, it is at least partially visible from the outside, and in the unfolding state, it is concealed by the first housing 110 and second housing 120 to be not visible from the outside.

According to various embodiments, the electronic device 100 may include at least one flexible printed circuit board 160 (e.g., FPCB, flexible printed circuit board, or FRC, flexible RF cable) to electrically connect at least one first electronic component disposed in the first space 1101 of the first housing 110 and at least one second electronic component disposed in the second space 1201 of the second housing 120. In an embodiment, at least one first electronic component may include a main printed circuit board (e.g., first printed circuit board 151 in FIG. 3). In an embodiment, at least one second electronic component may include a sub printed circuit board (e.g., second printed circuit board 152 in FIG. 3). In an embodiment, at least one first electronic component and/or at least one second electronic component may include at least one battery B1 or B2 disposed in the first space 1101 and/or second space 1201, at least one antenna radiator, at least one sensor module, or at least one input/output device. For example, the flexible printed circuit board 160 may be disposed to electrically connect various electronic components disposed in the first space 1101 and the second space 1201 to each other. In an embodiment, the flexible printed circuit board 160 may be disposed in such a manner that it penetrates the first through-hole 1131c formed in the first support member 1131 of the first housing 110 from the first space 1101, passes through the accommodation space 1411 of the hinge housing 141, and after penetrating the second through-hole 1231c formed in the second support member 1231 of the second housing 120, it is accommodated into the second space 1201. In an embodiment, the flexible printed circuit board 160 may be disposed in the accommodation space 1411 of the hinge housing 141 to have a shape and extra length for accommodating length changes due to the folding operation of the electronic device 100. For example, the flexible printed circuit board 160 may be formed to have a shape in the accommodation space 1411 that is bent at least once and capable of being elastically restored.

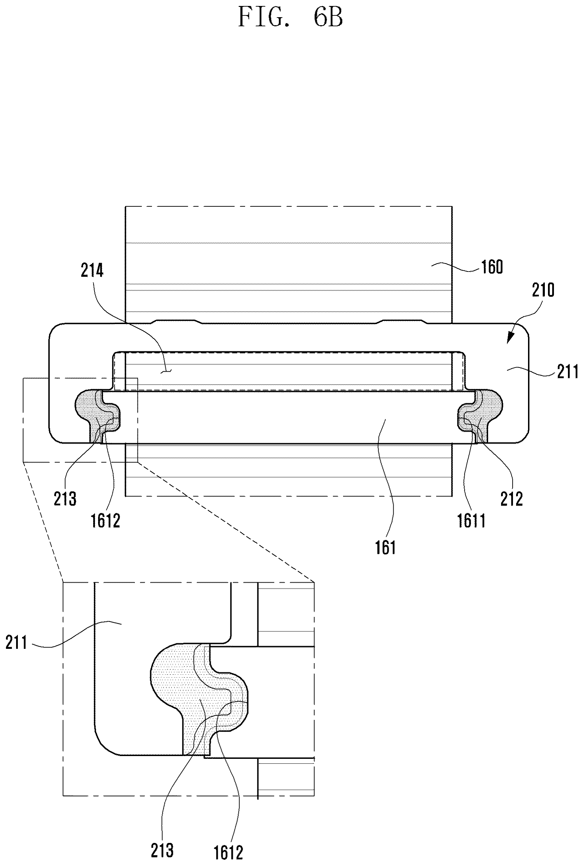

According to various embodiments, the electronic device 100 may include the first waterproof structure 200 to seal the first through-hole 1131c and the second waterproof structure 200-1 to seal the second through-hole 1231c. In an embodiment, the first and second waterproof structures 200 and 200-1 may prevent or reduce the infiltration of external moisture and/or foreign substances into the first space 1101 and the second space 1201 through the first and second through-holes 1131c and 1231c. In an embodiment, the first waterproof structure 200 may include a first waterproof member 210 that is coupled with a stiffener 161 fixed to the first support member 1131 and disposed on the flexible printed circuit board 160. In an embodiment, the first waterproof member 210 may include a loop structure (e.g., closed loop structure) having an opening (e.g., opening 214 in FIG. 6B) through which the flexible printed circuit board 160 passes, by being coupled with the stiffener 161. In an embodiment, the first waterproof member 210 and the stiffener 161 may be disposed on the first support member 1131 in such a manner that the loop structure surrounds the periphery of the first through-hole 1131c. In an embodiment, the first waterproof structure 200 may include a second waterproof member 220 disposed to seal the opening 214, and a fixing bracket 230 that is coupled with the first support member 1131 above the second waterproof member 220. In an embodiment, the first waterproof structure 200 may include the first support member 1131 and a third waterproof member 240 disposed between the first waterproof member 210 and stiffener 161. In an embodiment, the second waterproof structure 200-1 may have a configuration that is substantially identical to the first waterproof structure 200 and may seal the second through-hole 1231c.

The electronic device 100 according to an exemplary embodiment of the present disclosure may have a fixation structure for the stiffener 161, which is used to fix the flexible printed circuit board 160, configured together with the waterproof structure 200 and 200-1. This configuration helps secure a sufficient bending area 1142 for the flexible printed circuit board 160 according to the folding operation without increasing the thickness of the electronic device 100, thereby assisting in slimming down the electronic device 100 and/or improving assembly.

Hereinafter, the first waterproof structure 200 disposed on the first support member 1131 of the first housing 110 is illustrated and described. However, the second waterproof structure 200-1 disposed on the second support member 1231 of the second housing 120 may also have a layout configuration that is substantially identical.

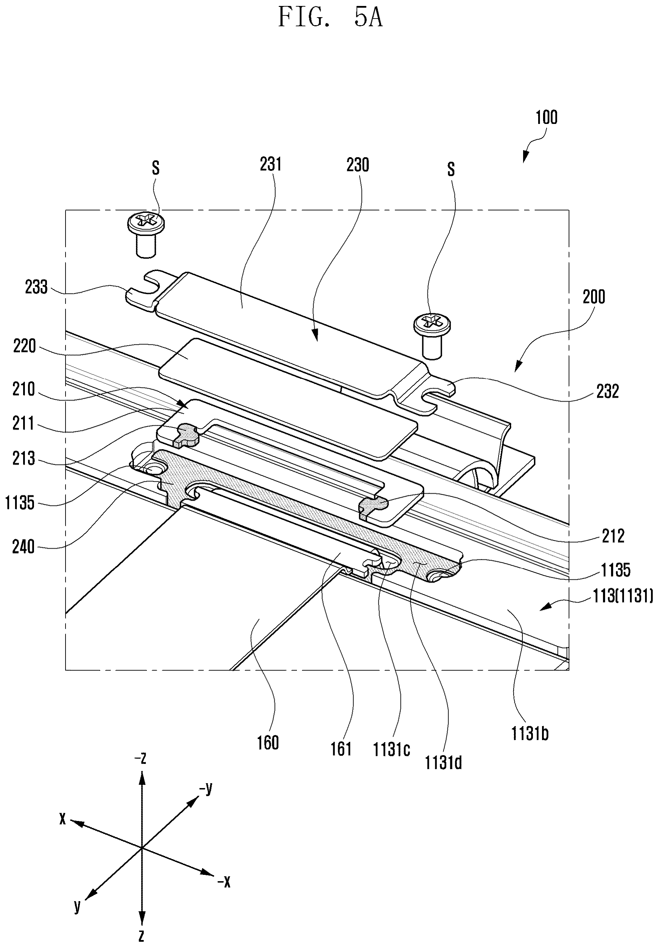

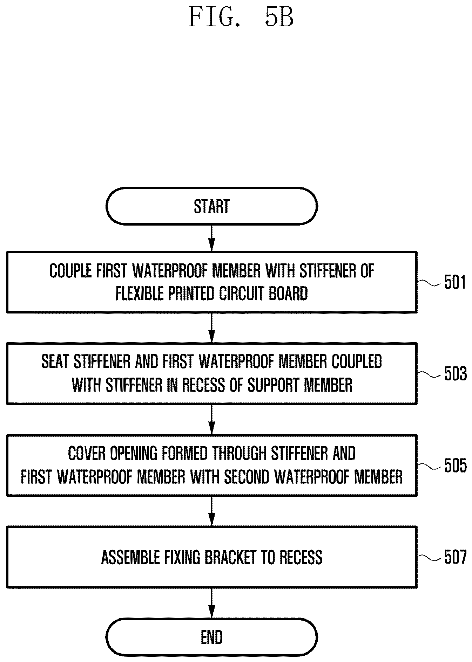

FIG. 5A is an exploded perspective view of a waterproof structure according to various embodiments of the present disclosure. FIG. 5B is a flowchart illustrating the assembly sequence of the waterproof structure according to various embodiments of the present disclosure.

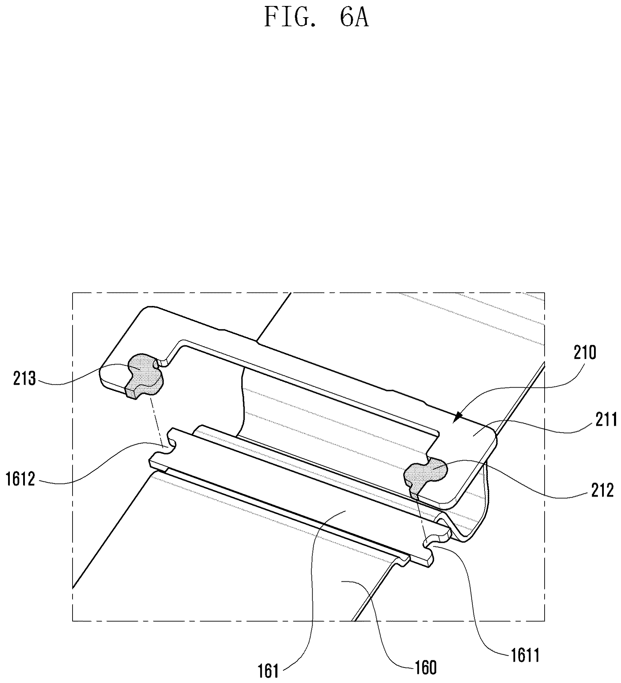

FIGS. 6A to 6G are views illustrating the coupling process according to various embodiments of the present disclosure.

With reference to FIGS. 5A to 6G, the electronic device 100 may include the first housing 110 including the first lateral member 113. In an embodiment, the first housing 110 may extend from the first lateral member 113 and include the first surface 1131a facing a first direction (e.g., z-axis direction) and the second surface 1131b facing a direction opposite to the first surface 1131a (e.g., -z-axis direction). In an embodiment, the first lateral member 113 may include a through-hole 1131c that penetrates from the first surface 1131a to the second surface 1131b. In an embodiment, the through-hole 1131c may be formed in a recess 1131d formed on the second surface 1131b of the first support member 1131. In an embodiment, the recess 1131d may be formed lower than the second surface 1131b. In an embodiment, the through-hole 1131c may be formed to have a length in a third direction (e.g., ±x-axis direction) that is perpendicular to the first direction and parallel to the surface of the flexible display 130.

According to various embodiments, the electronic device 100 may include the flexible printed circuit board 160 that passes through the through-hole 1131c. In an embodiment, the flexible printed circuit board 160 may penetrate through the through-hole 1131c from the first space (e.g., first space 1101 in FIG. 4) of the first housing 110 and then be withdrawn into the accommodate space (e.g., accommodation space 1411 in FIG. 4) of the hinge housing(e.g., hinge housing 141 in FIG. 4). In an embodiment, the flexible printed circuit board 160 may include the stiffener 161 that is at least partially attached or formed and disposed near the through-hole 1131c in the recess 1131d. In an embodiment, the stiffener 161 may be coupled to the flexible printed circuit board 160 and may be formed of a metal or polymer material. In an embodiment, the both ends of the stiffener 161 may include a pair of coupling grooves 1611 and 1612 that are recessed from the periphery.

According to various embodiments, the electronic device 100 may include the waterproof structure 200 (e.g., first waterproof structure 200 in FIG. 4) disposed through the through-hole 1131c in the recess 1131d to seal the through-hole 1131c that the flexible printed circuit board 160 passes through. In an embodiment, the waterproof structure 200 may include the first waterproof member 210 that is at least partially coupled with the stiffener 161, the second waterproof member 220 that is coupled with the first waterproof member 210 and the stiffener 161, and the fixing bracket 230 disposed above the second waterproof member 220 to fix the first waterproof member 210, the second waterproof member 220 and the stiffener 161 within the recess 1131d. In an embodiment, the fixing bracket 230 may include a plate portion 231 that is disposed to at least partially overlap the second waterproof member 220, and a pair of extensions 232 and 233 that extend from both ends of the plate portion 231 and are designed to be fastened into screw fastening holes 1135 formed in the recess 1131d using screws S. In an embodiment, the waterproof structure 200 may include the third waterproof member 240 applied to the recess 1131d along the periphery of the through-hole 1131c before the stiffener 161 and the first waterproof member 210 are disposed in the recess 1131d. In some embodiments, the third waterproof member 240 may be omitted.

According to various embodiments, the first waterproof member 210 may include a body 211 and a pair of coupling protrusions 212 and 213 formed at both ends of the body 211. In an embodiment, the first waterproof member 210 may have a partially opened loop shape, for example. In an embodiment, the first waterproof member 210 may be formed in a '⊏' shape. In an embodiment, the body 211 may be formed of a rigid material, and the pair of coupling protrusions 212 and 213 may be formed of a soft material with elasticity, which is coupled with the body 211. In an embodiment, the body 211 may be formed of metal or polycarbonate (PC). In an embodiment, the pair of coupling protrusions 212 and 213 may be formed of an elastic material such as silicone, rubber, or urethane. In an embodiment, the body 211 and the pair of coupling protrusions 212 and 213 may be coupled through injection molding. In some embodiments, the body 211 and the pair of coupling protrusions 212 and 213 may be coupled through an attachment manner such as bonding or taping. In some embodiments, the body 211 and the pair of coupling protrusions 212 and 213 may be coupled through a structural shape. In an embodiment, the stiffener 161 may include the pair of coupling protrusions 212 and 213. For example, the pair of coupling protrusions 212 and 213 may be formed of a soft material with elasticity, which is coupled with the stiffener 161. For example, the stiffener 161 and the pair of coupling protrusions 212 and 213 may be coupled through an attachment manner such as bonding or taping. In some embodiments, the stiffener 161 and the pair of coupling protrusions 212 and 213 may be coupled through a structural shape. In some embodiments, the coupling protrusions 212 and 213 may be formed on the stiffener. In this case, the coupling grooves 1611 and 1612, which are to couple with the coupling protrusions 212 and 213, may be formed on the first waterproof member 210. For example, the coupling grooves that couple with the body 211 may also be formed of an elastic material.

Hereinafter, the assembly sequence of the waterproof structure 200 is as follows.

With reference to FIGS. 5B to 6G, in the first operation 501, before the waterproof structure 200 is applied to the electronic device 100, the stiffener 161 of the flexible printed circuit board 160 and the first waterproof member 210 may be coupled first. In an embodiment, the first waterproof member 210 may be coupled in a manner where the pair of coupling protrusions 212 and 213 are inserted (e.g., press-fit) into the pair of coupling grooves 1611 and 1612 of the stiffener 161. In an embodiment, the pair of coupling protrusions 212 and 213 are formed of a soft material with elasticity, and are therefore tightly coupled to overlap the pair of coupling grooves 1611 and 1612, which helps maintain the waterproof functionality. In an embodiment, the opened loop shape of the first waterproof member 210 may be transformed into a closed loop shape through coupling with the stiffener 161, thereby forming the opening 214. Therefore, the flexible printed circuit board 160 may be penetrated through the through-hole 1131c below the opening 214.

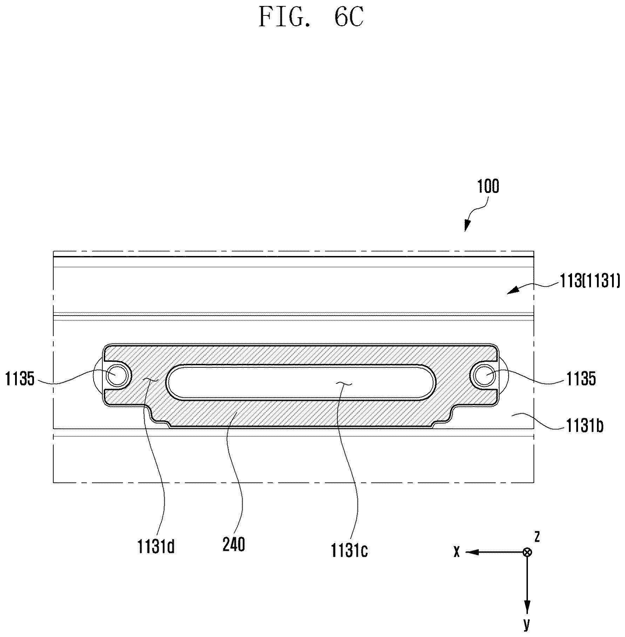

Then, as illustrated in FIG. 6C, the third waterproof member 240 may be disposed in the recess 1131d to surround the periphery of the through-hole 1131c. In an embodiment, the third waterproof member 240 may include a waterproof tape (e.g., double-sided tape) attached to the recess 1131d. In an embodiment, the third waterproof member 240 may be attached over the entire area of the recess 1131d, except for the through-hole 1131c and screw fastening holes 1135. In some embodiments, the third waterproof member 240 may be omitted.

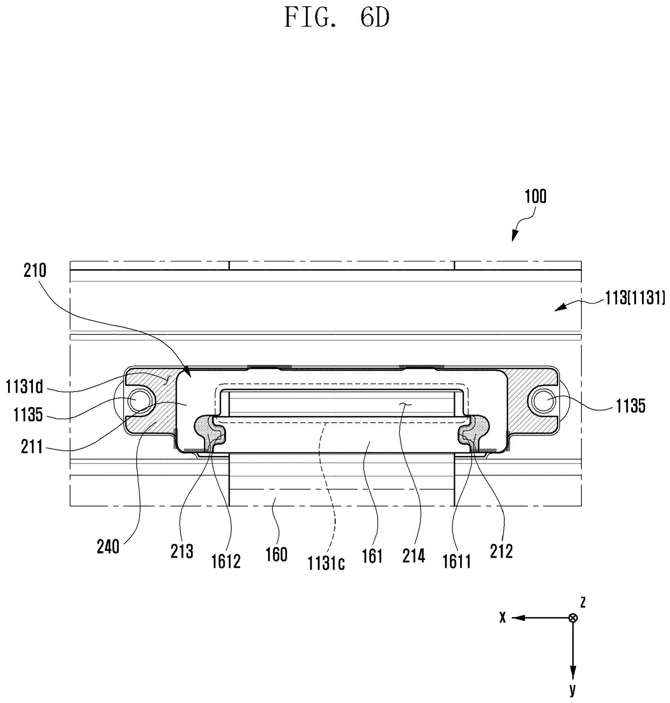

In the second operation 503, as illustrated in FIG. 6D, the stiffener 161 and the first waterproof member 210 coupled with the stiffener 161 may be seated in the recess 1131d. In this case, the stiffener 161 and the first waterproof member 210 coupled with the stiffener 161 may be disposed above the third waterproof member 240. In an embodiment, the closed loop structure formed by the stiffener 161 and the first waterproof member 210 may be disposed to contact along the periphery of the through-hole 1131c. For example, when the first waterproof member 210 is viewed from above, or when the second surface 1131b is viewed from above, the opening 214 may overlap the through-hole 1131c. In an embodiment, the opening 214 may be smaller than the through-hole 1131c. In some embodiments, the opening 214 may be formed to be substantially the same size as the through-hole 1131c. In some embodiments, the opening 214 may be formed larger than the through-hole 1131c. In an embodiment, once the stiffener 161 and the first waterproof member 210 coupled with the stiffener 161 are seated in the recess 1131d, the flexible printed circuit board 160 may be penetrated through the through-hole 1131c.

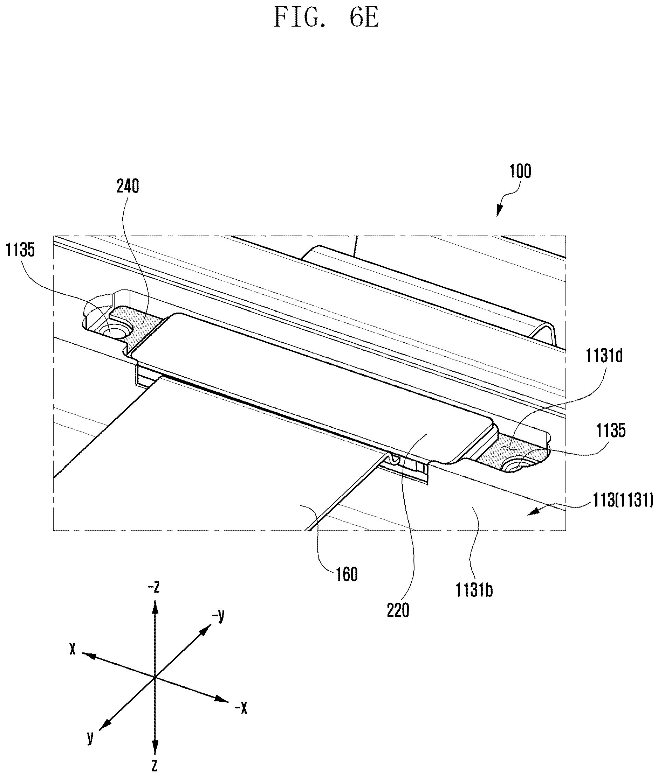

In the third operation 505, as illustrated in FIG. 6E, the second waterproof member 220 may be disposed above the stiffener 161 and the first waterproof member 210 to cover the opening 214. In an embodiment, the second waterproof member 220 may include a waterproof tape. In an embodiment, the second waterproof member 220 may include double-sided tape.

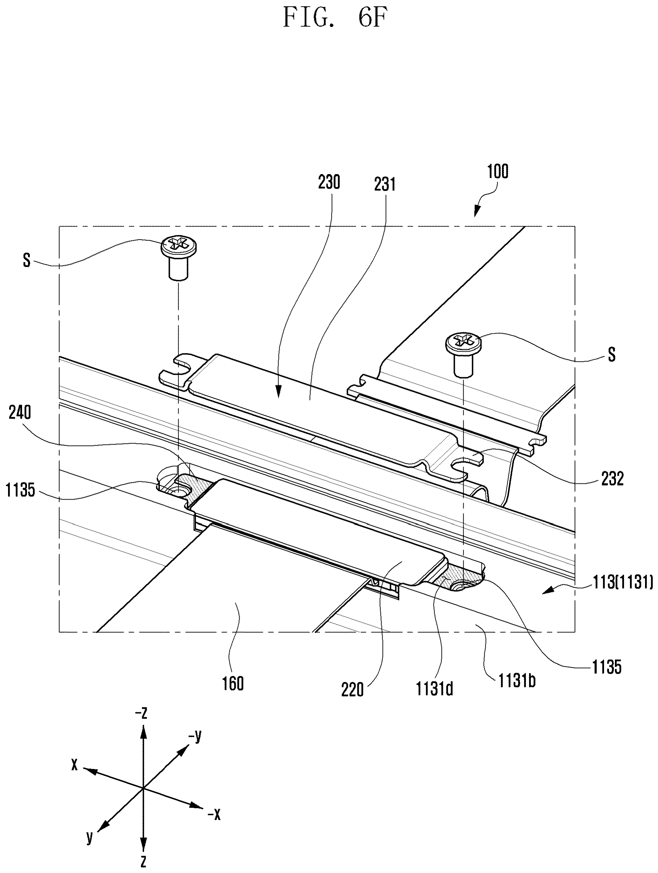

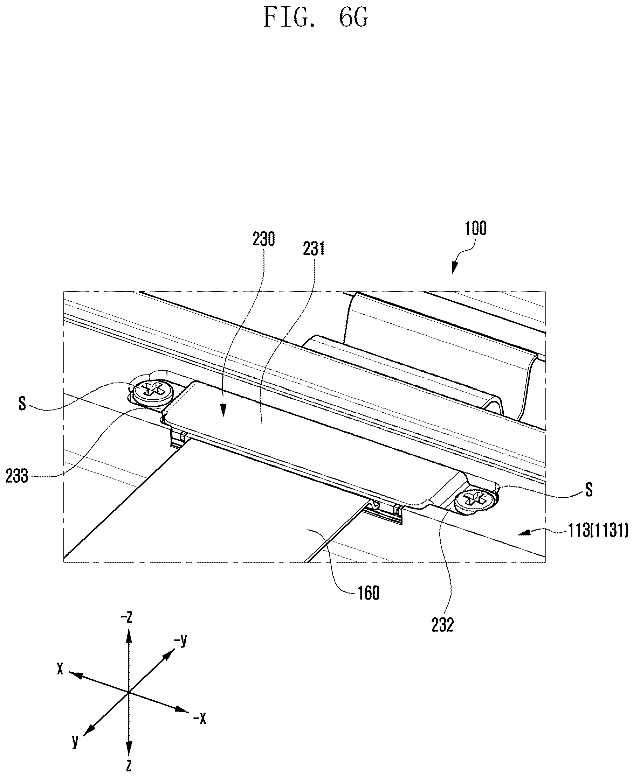

In the fourth operation 507, as illustrated in FIGS. 6F and 6G, the fixing bracket 230 may be fixed in such a manner that the plate portion 231 is disposed above the second waterproof member 220, and the extensions 232 and 233 at both ends are securely fastened into the screw fastening holes 1135 formed in the recess 1131d using screws S. In an embodiment, the plate portion 231 of the fixing bracket 230 may be formed to cover at least the opening 214 when the first waterproof member 210 is viewed from above, and may be disposed to overlap the opening 214. Therefore, the opening 214 covering the through-hole 1131c may be sealed through the second waterproof member 220 and the third waterproof member 240. In addition, the first, second, and third waterproof members 210, 220, and 240, along with the stiffener 161, may be securely fixed in the recess 1131d of the first housing 110 through the fixing bracket 230. In an embodiment, after the waterproof structure 200 is fully assembled, the plate portion 231 of the fixing bracket 230 may be configured to align with the second surface 1131b of the first support member 1131 or be disposed lower than the second surface 1131b within the recess 1131d.

The electronic device 100 according to an exemplary embodiment of the present disclosure, where the fixation structure of the stiffener 161 for fixing the flexible printed circuit board 160 is configured together with the waterproof structure 200, can help in slimming down the electronic device 100 and/or improving assembly by securing a sufficient bending area for the flexible printed circuit board 160 due to the folding operation, without increasing the thickness of the electronic device 100.

According to various embodiments, an electronic device may include a first housing (e.g., first housing 110 in FIG. 3) including at least one first electronic component (e.g., first printed circuit board 151 in FIG. 3), a second housing (e.g., second housing 120 in FIG. 3) including at least one second electronic component (e.g., second printed circuit board 152 in FIG. 3), a hinge device (e.g., hinge device 140 in FIG. 3) that rotatably connects the first housing and the second housing to each other, a flexible printed circuit board (e.g., flexible printed circuit board 160 in FIG. 4) that penetrates through a through-hole (e.g., through-holes 1131c and 1231c in FIG. 4) formed in the first housing and/or the second housing, and electrically connects at least one first electronic component and at least one second electronic component, and a waterproof structure (e.g., waterproof structures 200 and 200-1 in FIG. 4) disposed in the through-hole, in which the waterproof structure (e.g., first waterproof structure 200 in FIG. 4) may include a first waterproof member (e.g., first waterproof member 210 in FIG. 5A) coupled with a stiffener (e.g., stiffener 161 in FIG. 4) disposed on the flexible printed circuit board to form a loop structure that includes an opening (e.g., opening 214 in FIG. 6B), and a second waterproof member (e.g., second waterproof member 220 in FIG. 5A) disposed on the stiffener and the first waterproof member to cover the opening, in which the stiffener and the first waterproof member may be disposed on the first housing and/or the second housing in such a manner that the loop structure surrounds the periphery of the through-hole.

According to various embodiments, the first waterproof member includes an opened loop structure, and the opened loop structure may be transformed into a closed loop structure through coupling with the stiffener.

According to various embodiments, when the through-hole is viewed from above, the opening may overlap the through-hole.

According to various embodiments, the opening may be formed smaller than the through-hole.

According to various embodiments, the first waterproof member may include a body formed of a rigid material, and a pair of coupling protrusions formed of a soft material with elasticity, each coupled to both ends of the body.

According to various embodiments, the stiffener may include a pair of coupling grooves formed at both ends to couple with the pair of coupling protrusions.

According to various embodiments, the body may be formed of metal, and the pair of coupling protrusions may be formed of at least one of rubber, urethane, or silicone.

According to various embodiments, the electronic device may include a third waterproof member disposed between the first housing and/or second housing, and the stiffener and the first waterproof member. The third waterproof member may be disposed to cover the through-hole and/or the opening.

According to various embodiments, the second waterproof member and third waterproof member may include a waterproof tape.

According to various embodiments, the electronic device may include a fixing bracket that is disposed above the second waterproof member, overlapping at least a portion of the second waterproof member, and fixed to the first housing and/or the second housing.

According to various embodiments, the fixing bracket may include a plate portion disposed to overlap the second waterproof member, and a pair of extensions extending from both ends of the plate portion, which are configured to be fixed to the first housing and/or the second housing.

According to various embodiments, the fixing bracket may be fixed in such a manner that the pair of extensions are fastened to the first housing and/or the second housing through screws.

According to various embodiments, the through-hole may be formed in a recess formed in the first housing and/or the second housing.

According to various embodiments, the waterproof structure may be disposed not to protrude from the recess.

According to various embodiments, the at least one first electronic component may include a main printed circuit board, and the at least one second electronic component may include a sub printed circuit board.

According to various embodiments, an electronic device may include a first housing (e.g., first housing 110 in FIG. 3) including at least one first electronic component (e.g., first printed circuit board 151 in FIG. 3), a second housing (e.g., second housing 120 in FIG. 3) including at least one second electronic component (e.g., second printed circuit board 152 in FIG. 3), a hinge device (e.g., hinge device 140 in FIG. 3) that rotatably connects the first housing and the second housing to each other, a flexible printed circuit board (e.g., flexible printed circuit board 160 in FIG. 4) that penetrates through through-holes (e.g., through-holes 1131c and 1231c in FIG. 4) formed each in the first housing and the second housing, and electrically connects at least one first electronic component and at least one second electronic component, and waterproof structures (e.g., waterproof structures 200 and 200-1 in FIG. 4) each disposed in the through-holes, in which the waterproof structure (e.g., first waterproof structure 200 in FIG. 4) may include a first waterproof member (e.g., first waterproof member 210 in FIG. 5A) coupled with a stiffener (e.g., stiffener 161 in FIG. 4) disposed on the flexible printed circuit board to form a loop structure that includes an opening (e.g., opening 214 in FIG. 6B), a second waterproof member (e.g., second waterproof member 220 in FIG. 5A) disposed on the stiffener and the first waterproof member to cover the opening, a third waterproof member (e.g., third waterproof member 240 in FIG. 5A) disposed between the first housing and/or second housing, and the stiffener and the first waterproof member, and a fixing bracket (e.g., fixing bracket 230 in FIG. 5A) disposed to overlap at least part of the second waterproof member and fixed to the first housing and/or the second housing, in which the stiffener and the first waterproof member may be disposed on the first housing and the second housing in such a manner that the loop structure surrounds the periphery of the through-hole.

According to various embodiments, the first waterproof member includes an opened loop structure, and the opened loop structure may be transformed into a closed loop structure through coupling with the stiffener.

According to various embodiments, when the through-hole is viewed from above, the opening may overlap the through-hole.

According to various embodiments, the first waterproof member may include a body formed of a rigid material, and a pair of coupling protrusions formed of a soft material with elasticity, each coupled to both ends of the body.

According to various embodiments, the stiffener may include a pair of coupling grooves formed at both ends to couple with the pair of coupling protrusions.

In addition to the foregoing explanations, the following enumerated aspects are also relevant for the present disclosure as part of the specification which must not be confused with the appended claims (that follow after the specification):
Aspect 1: An electronic device, comprising: a first housing 110 including at least one first electronic component 151; a second housing 120 including at least one second electronic component 152; a hinge device 140 that rotatably connects the first housing and the second housing to each other; a flexible printed circuit board 160 that penetrates through through-holes 1131c, 1231c formed in the first housing and/or the second housing, and electrically connects the at least one first electronic component and the at least one second electronic component; and waterproof structures 200, 200-1 disposed in the through-holes, wherein the waterproof structure 200, 200-1 comprises: a first waterproof member 210 that couples with a stiffener 161 disposed on the flexible printed circuit board to form a loop structure including an opening 214; a second waterproof member 220 disposed on the stiffener and the first waterproof member to cover the opening, and wherein the stiffener and the first waterproof member are disposed on the first housing and/or the second housing in such a manner that the loop structure surrounds a periphery of the through-hole.
Aspect 2: The electronic device of aspect 1, wherein the first waterproof member includes an opened loop structure, and the opened loop structure is transformed into a closed loop structure through coupling with the stiffener.
Aspect 3: The electronic device of aspect 1 or 2, wherein, when the through-hole is viewed from above, the opening overlaps the through-hole.
Aspect 4: The electronic device of any one of aspects 1 to 3, wherein the opening is formed smaller than the through-hole.
Aspect 5: The electronic device of any one of aspects 1 to 4, wherein the first waterproof member comprises: a body formed of a rigid material; and a pair of coupling protrusions formed of a soft material with elasticity, each coupled to both ends of the body.
Aspect 6: The electronic device of aspect 5, wherein the stiffener includes a pair of coupling grooves formed at both ends to couple with the pair of coupling protrusions.
Aspect 7: The electronic device of aspect 5, wherein the body is formed of metal, and the pair of coupling protrusions are formed of at least one of rubber, urethane, or silicone.
Aspect 8: The electronic device of any one of aspects 1 to 7, comprising: a third waterproof member disposed between the first housing and/or second housing, and the stiffener and the first waterproof member, wherein the third waterproof member is disposed to cover the through-hole and/or the opening.
Aspect 9: The electronic device of aspect 8, wherein the second waterproof member and third waterproof member include a waterproof tape.
Aspect 10: The electronic device of any one of aspects 1 to 9, comprising: a fixing bracket disposed above the second waterproof member, overlapping at least a portion of the second waterproof member, and fixed to the first housing and/or the second housing.
Aspect 11: The electronic device of aspect 10, wherein the fixing bracket comprises:
   a plate portion disposed to overlap the second waterproof member; and a pair of extensions extending from both ends of the plate portion, which are configured to be fixed to the first housing and/or the second housing.
Aspect 12: The electronic device of aspect 11, wherein the fixing bracket is fixed in such a manner that the pair of extensions are fastened to the first housing and/or the second housing through screws.
Aspect 13: The electronic device of any one of aspects 1 to 12, wherein the through-hole is formed in a recess formed in the first housing and/or the second housing.
Aspect 14: The electronic device of aspect 13, wherein the waterproof structure is disposed not to protrude from the recess.
Aspect 15: The electronic device of any one of aspects 1 to 14, wherein the at least one first electronic component includes a main printed circuit board, and the at least one second electronic component includes a sub printed circuit board.

Further, the embodiments of the present disclosure disclosed in the present specification and illustrated in the drawings are provided as particular examples for easily explaining the technical contents according to the embodiment of the present disclosure and helping understand the embodiment of the present disclosure, but not intended to limit the scope of the embodiment of the present disclosure.

## Claims

1. An electronic device (100) comprising:
a first housing (110) having a through-hole (1131c);
a second housing (120);
a hinge device (140) coupling the first housing (110) and the second housing (120);
a flexible printed circuit board (160) disposed to penetrate through the through-hole (1131c), and electrically connected with a first electronic component in the first housing (110) and a second electronic component in the second housing (120);
a stiffener (161) disposed on the flexible printed circuit board (160) and attached to the first housing (110);
a first waterproof member (210) disposed in or adjacent to the through-hole (1131c) such that the stiffener (161) and the first waterproof member (210), when coupled to each other, form a loop structure having an opening (214) at least partially overlapped with the through-hole (1131c);
a second waterproof member (220) disposed to seal the opening (214), wherein the second waterproof member (210) seals the through hole (1131c); and
a fixing bracket (230) disposed over the stiffener (161) and the first waterproof member (210) to cover the opening (214).

2. The electronic device (100) of claim 1, wherein the flexible printed circuit board (160) and the stiffener (161) are disposed in a space between the fixing bracket (230) and the first housing (110).

3. The electronic device (100) of claim 1 or 2, wherein the opening (214) is at least partially aligned with the through-hole (1131c).

4. The electronic device (100) of any of claims 1 to 3 wherein a size of the opening (214) is smaller than a size of the through-hole (1131c).

5. The electronic device (100) of any of claims 1 to 4, wherein the fixing bracket (230) includes a plate portion (231) at least partially overlapped with the stiffener (161) and the first waterproof member (210).

6. The electronic device (100) of claim 5, wherein the fixing bracket (230) includes a pair of extensions (232, 233) that respectively extended from opposite ends of the plate portion (231),
wherein the pair of extensions (232, 233) is coupled with the first housing (110).

7. The electronic device (100) of claim 6, wherein the pair of extensions (232, 233) are fastened to the first housing (110) through screws.

8. The electronic device (100) of any of claims 1 to 7, wherein the through-hole (1131c) is formed in a recess (1131d) in the first housing (110).

9. The electronic device (100) of claim 8, wherein the recess (1131d) is deeper than a thickness of the first waterproof member (210).

10. The electronic device (100) of any of claims 1 to 9, wherein the first electronic component includes a main printed circuit board (151), and
wherein the second electronic component includes a sub printed circuit board (152).

11. The electronic device (100) of any of claims 1 to 10, wherein the second housing (120) has another a through-hole (1231c), and the flexible printed circuit board (160) is disposed to penetrate through the other through-hole (1231c) of the second housing (120).

12. The electronic device (100) of claim 11, further comprising:
another stiffener disposed on the flexible printed circuit board (160);
a third waterproof member (240) disposed in or adjacent to the other through-hole (1131c) such that the other stiffener and the third waterproof member (240) form another loop having another opening (214) at least partially overlapped with the other through-hole (1131c);
a fourth waterproof member disposed to be at least partially overlapped with the other opening (214), the fourth waterproof member sealing at least the other through hole (1131c) through the other opening (214); and
another fixing bracket disposed over the other stiffener and the third waterproof member (240) to cover the other opening (214).

13. The electronic device of any of claims 1 to 12, wherein the flexible printed circuit board (160) and the stiffener (161) are in a space between the fixing bracket (230) and the first housing (110).
